# EUROPÄISCHE PATENTSCHRIFT

(11) **EP 1 168 600 B1**
(45) Veröffentlichungstag und Bekanntmachung des Hinweises auf die Patenterteilung: **20.02.2008**
(21) Anmeldenummer: 01114252.8
(22) Anmeldetag: 12.06.2001
(51) Int. Cl.: H03F 1/08

(54) **Schaltung und Verfahren zur Abschwächung oder Beseitigung unerwünschter Eigenschaften eines Operationsverstärkers**
Circuit and method for attenuating or eliminating of undesired properties of an operational amplifier
Circuit et méthode pour atténuer ou éliminer des propriétés non désirées d'un amplificateur opérationnel

(30) Priorität: 27.06.2000 DE 10031190
(43) Veröffentlichungstag der Anmeldung: 02.01.2002
(73) Patentinhaber: Infineon Technologies AG, 81669 München (DE)
(72) Erfinder: Engl, Bernhard, 83714 Miesbach (DE)
(74) Vertreter: Jannig, Peter

(56) Entgegenhaltungen:
- DE-A1- 19 833 968
- US-A- 5 900 748
- PATENT ABSTRACTS OF JAPAN Bd. 012, Nr. 489 (E-696), 21. Dezember 1988 (1988-12-21) -& JP 63 204911 A (MITSUBISHI ELECTRIC CORP), 24. August 1988 (1988-08-24)
- PATENT ABSTRACTS OF JAPAN Bd. 011, Nr. 161 (E-509), 23. Mai 1987 (1987-05-23) -& JP 61 293008 A (HITACHI LTD), 23. Dezember 1986 (1986-12-23)
- PATENT ABSTRACTS OF JAPAN Bd. 011, Nr. 227 (E-526), 23. Juli 1987 (1987-07-23) -& JP 62 043913 A (OKI ELECTRIC IND CO LTD), 25. Februar 1987 (1987-02-25)
- PATENT ABSTRACTS OF JAPAN Bd. 014, Nr. 550 (E-1009), 6. Dezember 1990 (1990-12-06) -& JP 02 235425 A (ASAHI KASEI MICRO SYST KK), 18. September 1990 (1990-09-18)
- PATENT ABSTRACTS OF JAPAN Bd. 015, Nr. 454 (E-1135), 19. November 1991 (1991-11-19) -& JP 03 195109 A (MITSUBISHI ELECTRIC CORP), 26. August 1991 (1991-08-26)
- PATENT ABSTRACTS OF JAPAN Bd. 1999, Nr. 01, 29. Januar 1999 (1999-01-29) -& JP 10 276050 A (HITACHI LTD; HITACHI TOBU SEMICONDUCTOR LTD), 13. Oktober 1998 (1998-10-13)
- PATENT ABSTRACTS OF JAPAN Bd. 2000, Nr. 10, 17. November 2000 (2000-11-17) -& JP 2000 201038 A (YOZAN INC), 18. Juli 2000 (2000-07-18)

## Beschreibung

Die vorliegende Erfindung betrifft eine Vorrichtung gemäß dem Oberbegriff des Patentanspruchs 1 und ein Verfahren gemäß dem Oberbegriff des Patentanspruchs 12, d.h. eine Kompensationsschaltung und ein Verfahren zur Abschwächung oder Beseitigung unerwünschter Eigenschaften eines Operationsverstärkers.

Operationsverstärker sind seit vielen Jahren in unzähligen Ausführungsformen bekannt.

Ein idealer Operationsverstärker hat über der gesamten Frequenzachse einen unendlich hohen Eingangswiderstand, keinen Ausgangswiderstand, eine unendlich hohe Verstärkung, und eine Reihe weiterer idealer Eigenschaften.

In der Realität sind Operationsverstärker allerdings nicht ideal. Die genannten Eigenschaften weisen mehr oder weniger große Abweichungen vom Idealfall auf, wobei diese Abweichungen häufig auch noch nichtlinear sind.

Besonders unangenehm wirkt sich hierbei der Umstand aus, daß sich eine von der Frequenz der Eingangssignale abhängende Phasenverschiebung zwischen den Eingangssignalen und dem Ausgangssignal des Operationsverstärkers einstellt. Diese Phasenverschiebung kann bewirken, daß eine Gegenkopplung vom Ausgangsanschluß des Operationsverstärkers auf den invertierenden Eingangsanschluß desselben zu einer Mitkopplung wird, wodurch der Operationsverstärker instabil wird. Um dies zu vermeiden, muß eine Korrektur des Frequenzganges durchgeführt werden. Bei dieser Korrektur wird dafür gesorgt, daß der Verstärkungsfaktor des Operationsverstärkers für Frequenzen, bei welchen die Phasenverschiebung Werte annimmt, die für die Stabilität des Operationsverstärkers kritisch werden können, auf Werte reduziert wird, die kleiner als 1 sind.

Hierzu müssen der Aufbau und/oder die äußere Beschaltung des Operationsverstärkers verändert werden, wobei die Veränderung meist die Hinzufügung einer Kapazität umfaßt; eine der bekanntesten Möglichkeiten zur Frequenzgangskorrektur ist die sogenannte Millerkompensation. Ein Beispiel für eine automatische Kompensationsschaltung welche eine Schwingneigung eines Operationsverstärkers detektiert und in Folge verhindert ist im japanischen Patent JP63204911 offenbart.

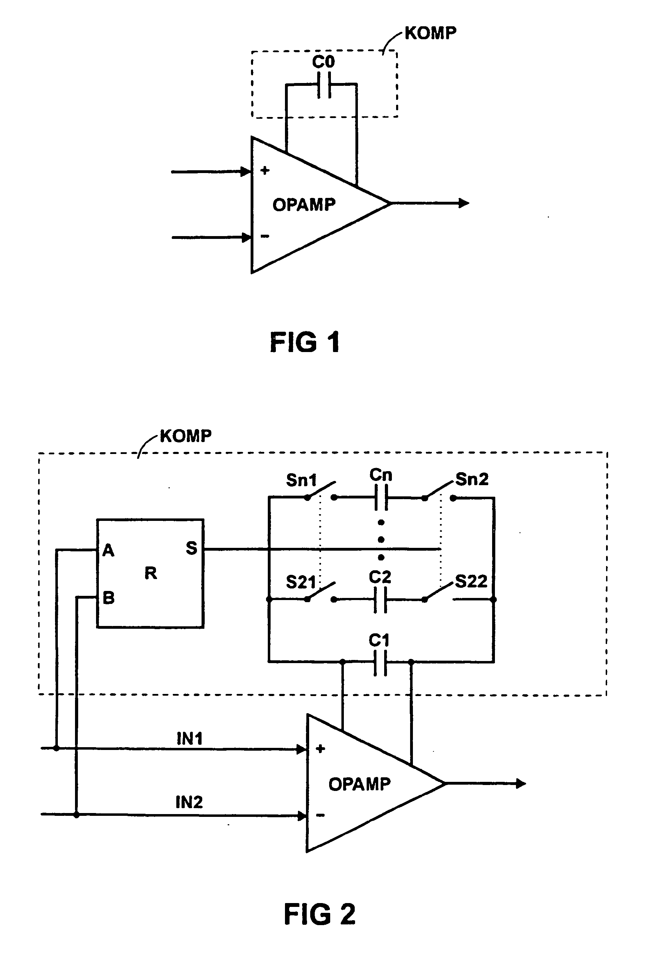

In der Figur 1 ist schematisch ein Operationsverstärker mit einer zur Frequenzgangskorrektur dienenden Kompensationsschaltung dargestellt. Dabei sind der Operationsverstärker mit dem Bezugszeichen OPAMP bezeichnet, und die Kompensationsschaltung mit dem Bezugszeichen KOMP. Die Kompensationsschaltung KOMP besteht im betrachteten Beispiel aus einem Kondensator C0, dessen Anschlüsse mit ausgewählten Punkten innerhalb des Operationsverstärkers OPAMP verbunden sind.

Durch die Kompensationsschaltung KOMP kann erreicht werden, daß der Operationsverstärker mit einer ausreichend hohen Phasenreserve betrieben wird und damit unter allen Umständen stabil läuft.

Die Kompensationsschaltung KOMP hat aber auch Auswirkungen auf andere Parameter des Operationsverstärkers. Die (Kompensations-)Kapazität des Kondensators C0 wirkt sich nämlich unter anderem auch auf die Slew-Rate und das Verstärkungs-Bandbreite-Produkt des Operationsverstärkers aus.

Die Slew-Rate ist im allgemeinen weitgehend unabhängig von der Topologie der Schaltung proportional zu I/C, und das Verstärkungs-Bandbreite-Produkt ist, ebenfalls weitgehend unabhängig von der Topologie der Schaltung, proportional zu Gm/C, wobei I der zur Verfügung stehende Strom ist, Gm die Steilheit der im Operationsverstärker enthaltenen Transistoren, und C die Kompensationskapazität. Mit größer werdender Kompensationskapazität C sinken also die Slew-Rate und das Verstärkungs-Bandbreite-Produkt. Dies läßt sich im allgemeinen nicht durch eine Erhöhung vom I bzw. Gm ausgleichen, weil man sich hier meistens schon an der Grenze des Machbaren bewegt.

Gute (hohe) Werte für die Slew-Rate und das Verstärkungs-Bandbreite-Produkt lassen sich also nur erzielen, wenn die Kompensationskapazität C nicht zu hoch ist. Andererseits darf die Kompensationskapazität C aber auch nicht zu klein werden, weil sonst wieder zu befürchten ist, daß der Operationsverstärker instabil wird.

Für die Kompensationskapazität C gibt es daher einen optimalen Wert oder Wertebereich, der nicht wesentlich unterschritten oder überschritten werden sollte oder darf.

Dies erweist sich insbesondere dann, wenn der Kondensator in eine den Operationsverstärker bildende oder enthaltende integrierte Schaltung integriert ist, als sehr schwierig. Die Kapazitäten von in integrierten Schaltungen integrierten Kondensatoren können nämlich sehr hohe Toleranzen aufweisen (bis zu ±40%). Zwar können die Kondensatoren beispielsweise durch Trimmen mit einem Laser auf die gewünschte Kapazität gebracht werden, doch ist dieser Vorgang sehr aufwendig und teuer. Eine mögliche Alternative hierzu besteht darin, den Kondensator außerhalb der den Operationsverstärker bildenden oder enthaltenden integrierte Schaltung vorzusehen. Dann ist aber der Einsatz des Operationsverstärkers kompliziert und aufwendig.

Solche und ähnliche Probleme können nicht nur bei der Frequenzgangskorrektur, sondern auch bei der Abschwächung oder Beseitigung anderer unerwünschter Eigenschaften des Operationsverstärkers auftreten.

Der vorliegenden Erfindung liegt daher die Aufgabe zugrunde, die Kompensationsschaltung gemäß dem Oberbegriff des Patentanspruchs 1 und das Verfahren gemäß dem Oberbegriff des Patentanspruch 14 derart weiterzubilden, daß sich mit geringem Aufwand und auf einfache Art und Weise zuverlässig eine wunschgemäße Abschwächung oder Beseitigung von unerwünschten Eigenschaften des Operationsverstärkers erzielen läßt.

Diese Aufgabe wird erfindungsgemäß durch die in Patentanspruch 1 beanspruchte Kompensationsschaltung bzw. durch das in Patentanspruch 14 beanspruchte Verfahren gelöst.

Die erfindungsgemäße Kompensationsschaltung zeichnet sich dadurch aus, daß deren Elemente zumindest teilweise selektiv aktivierbar und deaktivierbar und/oder unterschiedlich mit anderen Elementen der Kompensationsschaltung und/oder dem Operationsverstärker verschaltbar sind; das erfindungsgemäße Verfahren zeichnet sich dadurch aus, daß sich innerhalb oder außerhalb des Operationsverstärkers einstellende Verhältnisse, die Rückschlüsse auf das Vorliegen und/oder das Ausmaß der unerwünschten Eigenschaften des Operationsverstärkers gestatten, ermittelt werden, und daß eine zur Abschwächung oder Beseitigung der unerwünschten Eigenschaften des Operationsverstärkers vorgesehene Kompensationssschaltung abhängig vom Ergebnis der Ermittlung gesteuert wird.

Dadurch kann auch dann, wenn sich die zur Kompensation benötigten Elemente nur mit großen Toleranzen herstellen lassen gewährleistet werden, daß der Operationsverstärker unter allen Umständen stets wunschgemäß schnell und stabil arbeitet. Es kann sogar eine dynamische Anpassung an die jeweils aktuellen Bedingungen und Anforderungen vorgenommen werden.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: eine einen Operationsverstärker und eine herkömmliche Kompensationsschaltung zur Korrektur des Frequenzganges des Operationsverstärkers enthaltende Anordnung,
- Figur 2: eine einen Operationsverstärker und die nachfolgend näher beschriebene Kompensationsschaltung zur Korrektur des Frequenzganges des Operationsverstärkers enthaltende Anordnung,
- Figur 3: den Aufbau eines in der Figur 2 gezeigten Reglers R,
- Figur 4: den Aufbau eines in der Figur 3 gezeigten Gleichgewichtsdetektors GGD,
- Figur 5: den Aufbau einer in der Figur 3 gezeigten Steuereinrichtung SE, und
- Figur 6: ein Ablaufdiagramm zur Veranschaulichung der Funktion einer in der Steuereinrichtung SE enthaltenen state machine.

Durch die nachfolgend näher beschriebene Kompensationsschaltung und das nachfolgend näher beschriebene Verfahren soll Einfluß auf den Frequenzgang eines Operationsverstärkers genommen werden, damit dieser eine so große Phasenreserve aufweist, daß er unter allen Umständen stabil läuft. Die nachfolgend beschriebenen Besonderheiten der Kompensationsschaltung und des Verfahrens lassen sich jedoch auch bei Kompensationsschaltungen und Verfahren einsetzen, durch die beliebige andere unerwünschte Eigenschaften eines Operationsverstärkers abgeschwächt oder beseitigt werden sollen.

Die Korrektur des Frequenzganges erfolgt beim betrachteten Beispiel durch die sogenannte Millerkompensation. Diese besteht darin, daß zwischen zwei ausgewählten Stellen des Operationsverstärkers eine Kapazität eingefügt wird. Die nachfolgend beschriebenen Besonderheiten der Kompensationsschaltung und des Verfahrens lassen sich jedoch auch bei Kompensationsschaltungen und Verfahren einsetzen, die die Korrektur des Frequenzganges auf andere Art und Weise bewerkstelligen.

Die betrachtete Kompensationsschaltung weist die Besonderheit auf, daß die Elemente der Kompensationssschaltung zumindest teilweise selektiv aktivierbar und deaktivierbar und/oder unterschiedlich mit anderen Elementen der Kompensationsschaltung und/oder dem Operationsverstärker verschaltbar sind.

Ob und gegebenenfalls welche Elemente der Kompensationsschaltung aktiviert oder deaktiviert werden, und/oder welche Elemente wie mit anderen Elementen der Kompensationsschaltung und/oder dem Operationsverstärker verschaltet werden, hängt von sich innerhalb oder außerhalb des Operationsverstärkers einstellenden Verhältnissen ab, die Rückschlüsse auf das Vorliegen und/oder das Ausmaß der unerwünschten Eigenschaften des Operationsverstärkers gestatten. Diese Verhältnisse werden ermittelt, und abhängig hiervon wird die Kompensationsschaltung gesteuert.

Ein mit einer solchen Kompensationsschaltung versehener Operationsverstärker ist in Figur 2 dargestellt. Dabei sind der Operationsverstärker wieder mit dem Bezugszeichen OPAMP, und die Kompensationsschaltung wieder mit dem Bezugszeichen KOMP bezeichnet.

Der Operationsverstärker OPAMP ist im betrachteten Beispiel als integrierte Schaltung ausgebildet oder Bestandteil einer integrierten Schaltung. Die Kompensationsschaltung KOMP ist auf der den Operationsverstärker enthaltenden integrierten Schaltung untergebracht. Der Operationsverstärker und/oder die Kompensationsschaltung können aber auch auf verschiedenen integrierten Schaltungen vorgesehen sein, und können unabhängig voneinander auch als normale (nicht integrierte) Schaltungen ausgebildet sein.

Der Operationsverstärker OPAMP ist ein "normaler" Operationsverstärker, der keine Besonderheiten aufweisen muß.

Die Kompensationsschaltung KOMP unterscheidet sich jedoch von der herkömmlichen Kompensationsschaltung gemäß Figur 1. Sie weist anstelle von nur einem Kondensator C0 eine Vielzahl von parallel geschalteten Kondensatoren C1 bis Cn auf, und enthält zusätzlich einen Regler R, durch welchen einzelne, mehrere oder alle Kondensatoren der Kondensatoren C1 bis Cn aktivierbar und deaktivierbar sind.

Die Kondensatoren können gleiche oder unterschiedliche Kapazitäten aufweisen.

Im betrachteten Beispiel sind "nur" die Kondensatoren C2 bis Cn aktivierbar und deaktivierbar; der Kondensator C1 ist immer aktiv und kann nicht abgeschaltet werden. Wie bereits angedeutet wurde, besteht hierauf keine Einschränkung. Grundsätzlich können beliebige und beliebig viele (auch alle) Kondensatoren aktivierbare und deaktivierbare Kondensatoren sein.

Zur Aktivierung und Deaktivierung und Deaktivierung der Kondensatoren C2 bis Cn sind in den diese enthaltenden Zweigen diesseits und jenseits der Kondensatoren Schalter vorgesehen. Diese Schalter sind in der Figur 2 mit S21 und S22 (für den Kondensator C2) und Sn1 und Sn2 (für den Kondensator Cn) bezeichnet. Im aktivierten Zustand der Kondensatoren sind die ihnen zugeordneten Schalter geschlossen, wodurch die betreffenden Kondensatoren zum Kondensator C1 und den weiteren aktivierten Kondensatoren parallel geschaltet sind und sich die Kapazitäten dieser Kondensatoren addieren; im deaktivierten Zustand der Kondensatoren sind die ihnen zugeordneten Schalter geöffnet, wodurch diese Kondensatoren keine Wirkung entfalten.

Das Öffnen und Schließen der Schalter S21 bis Sn2 erfolgt durch den Regler R. Der Regler ist in der Lage, die Kondensatoren C2 bis Cn einzeln und unabhängig voneinander zu aktivieren und zu deaktivieren. Dabei werden die einem Kondensator zugeordneten Schalter, also beispielsweise die Schalter S21 und S22 oder die Schalter Sn1 und Sn2 jeweils gleichzeitig geöffnet oder geschlossen.

Der Regler R öffnet und schließt die Schalter S21 bis Sn2 in Abhängigkeit davon, ob der Operationsverstärker wunschgemäß schnell und stabil läuft oder nicht; der Regler R ermittelt hierzu bestimmte Verhältnisse, die Rückschlüsse darauf zulassen, ob der Operationsverstärker stabil läuft oder nicht, und steuert abhängig vom Ergebnis der Ermittlung die Schalter S21 bis Sn2 an.

Die Verhältnisse, die ermittelt werden, um entscheiden zu können, ob der Operationsverstärker wunschgemäß schnell und stabil läuft oder nicht, bestehen im betrachteten Beispiel in der Dauer und/oder im Verlauf des Einschwingvorganges des Operationsverstärkers. Die Dauer und/oder der Verlauf des Einschwingvorganges werden im betrachteten Beispiel anhand des Größenverhältnisses oder des zeitlichen Verlaufes des Größenverhältnisses der sich an den Eingangsanschlüssen IN1 und IN2 des Operationsverstärkers einstellenden Spannungen ermittelt. Dieses Größenverhältnis oder der zeitliche Verlauf desselben sind bei einem gegengekoppelten Operationsverstärker ein zuverlässiges Kriterium dafür, ob der Operationsverstärker wunschgemäß schnell und stabil arbeitet: sind die sich an den Eingangsanschlüssen IN1 und IN2 des Operationsverstärkers einstellenden Spannungen ungefähr gleich groß, so befindet sich der Operationsverstärker im eingeschwungenen Zustand; sind die Spannungen bei sich nicht oder nur langsam ändernden Verhältnissen am Operationsverstärker ungleich, oder abwechselnd gleich und ungleich, so befindet sich der Operationsverstärker (noch) nicht im eingeschwungenen Zustand oder ist der Operationsverstärker instabil.

Die Auswertung des Größenverhältnisses der sich an den Eingangsanschlüssen IN1 und IN2 des Operationsverstärkers einstellenden Spannungen oder des zeitlichen Verlaufes der Größenordnung kann auf verschiedene Art und Weise erfolgen.

Eine erste Möglichkeit besteht darin, die Zeit zu ermitteln, die vergeht, bis die sich an den Eingangsanschlüssen IN1 und IN2 des Operationsverstärkers einstellenden Spannungen nach einem Ereignis, das eine den Operationsverstärker aus dem Gleichgewicht bringende Veränderung dieser Spannungen zur Folge hat, wieder gleich groß sind, und zu überprüfen,
(1) ob die ermittelte Zeit größer oder kleiner als eine (vorzugsweise wunschgemäß festlegbare und/oder veränderbare) maximale Dauer ist, und
(2) ob das Größenverhältnis der sich an den Eingangsanschlüssen IN1 und IN2 des Operationsverstärkers einstellenden Spannungen (bei sich nicht oder nur langsam ändernden Verhältnissen am Operationsverstärker) danach gleich bleibt.

Aus dem Ergebnis der ersten Überprüfung (1) läßt sich ersehen, ob der Operationsverstärker ausreichend schnell arbeitet. Ist die ermittelte Zeit größer als die festgelegte maximale Dauer, so arbeitet der Operationsverstärker zu langsam. Dies kann korrigiert werden, indem ein oder mehrere der Kondensatoren C2 bis Cn (durch Öffnen der zugeordneten Schalter) abgeschaltet werden.

Aus dem Ergebnis der zweiten Überprüfung (2) läßt sich ersehen, ob der Operationsverstärker stabil läuft. Sind die sich an den Eingangsanschlüssen IN1 und IN2 des Operationsverstärkers einstellenden Spannungen schnell abwechselnd gleich und ungleich, so deutet dies auf eine Schwingung des Operationsverstärkers hin. Reißt diese Schwingung nicht ab, so ist der Operationsverstärker instabil (zum Oszillator geworden). Dies kann korrigiert werden, indem ein oder mehrere der Kondensatoren C2 bis Cn (durch Schließen der zugeordneten Schalter) zugeschaltet werden.

Anstelle der zweiten Überprüfung (2) kann vorgesehen werden, zu überprüfen, ob die ermittelte Zeit (die Zeit, die vergeht, bis die sich an den Eingangsanschlüssen IN1 und IN2 des Operationsverstärkers einstellenden Spannungen nach einem Ereignis, das eine den Operationsverstärker aus dem Gleichgewicht bringende Veränderung dieser Spannungen zur Folge hat, wieder gleich groß sind) kürzer als eine (vorzugsweise wunschgemäß festlegbare und/oder auf veränderbare) minimale Dauer ist.

Auch hieraus läßt sich ersehen, ob der Operationsverstärker stabil läuft. Ist die ermittelte Zeit kleiner als die festgelegte minimale Dauer, läuft der Operationsverstärker vermutlich instabil. Diese Schlußfolgerung ist gerechtfertigt, weil eine kurze Dauer des Einschwingvorganges des Operationsverstärkers darauf schließen läßt, daß die Kompensationskapazität sehr klein ist, und weil eine zu kleine Kompensationskapazität nicht zuverlässig ausschließen kann, daß der Operationsverstärker instabil wird.

Im betrachteten Beispiel werden die vorstehend genannten ersten Überprüfung (1) und die soeben beschriebene alternative zweite Überprüfung durchgeführt; die Durchführung dieser Überprüfungen erfolgt im Regler R.

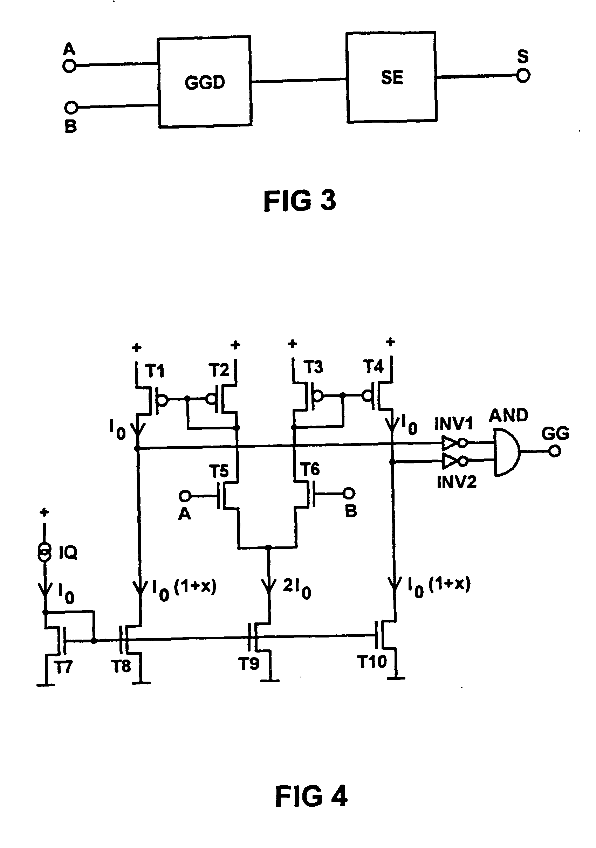

Ein möglicher Aufbau des Reglers R ist in Figur 3 dargestellt; er enthält einen Gleichgewichtsdetektor GGD und eine Steuereinrichtung SE.

Der Gleichgewichtsdetektor GGD ermittelt, ob die sich an den Eingangsanschlüssen IN1 und IN2 des Operationsverstärkers einstellenden Spannungen ungefähr gleich groß sind oder nicht und übermittelt das in den Figuren mit GG bezeichnete Ergebnis an die Steuereinrichtung SE. Die Steuereinrichtung SE mißt die Zeit, die nach einem Ereignis, das eine den Operationsverstärker aus dem Gleichgewicht bringende Veränderung der an den Eingangsanschlüssen IN1 und IN2 des Operationsverstärkers anliegenden Spannungen zur Folge hat, vergeht, bis die sich an den Eingangsanschlüssen IN1 und IN2 des Operationsverstärkers einstellenden Spannungen wieder ungefähr gleich groß sind, und steuert abhängig hiervon die Schalter S21 bis Sn2.

Ein möglicher Aufbau des Gleichgewichtsdetektors GGD ist in Figur 4 dargestellt.

Der Gleichgewichtsdetektor GGD besteht im betrachteten Beispiel aus Transistoren T1 bis T10, einer Stromquelle IQ, Invertern INV1 und INV2, und einem UND-Glied AND, welche wie in der Figur 4 gezeigt verschaltet sind.

Es handelt sich um eine Differenzstufe, die feststellen kann, ob die an den Eingangsanschlüssen IN1 und IN2 des Operationsverstärkers anliegenden und dem Gleichgewichtsdetektor GGD über Eingangsanschlüsse A und B desselben zugeführten Spannungen gleich groß sind. Es wird ein Signal GG = 1 ausgegeben, wenn die sich an den Eingangsanschlüssen IN1 und IN2 des Operationsverstärkers einstellenden Spannungen ungefähr gleich groß sind, und es wird ein Signal GG = 0 ausgegeben, wenn die sich an den Eingangsanschlüssen IN1 und IN2 des Operationsverstärkers einstellenden Spannungen unterschiedlich hoch sind; die Spannungsdifferenz, die überschritten werden muß, damit die sich an den Eingangsanschlüssen IN1 und IN2 des Operationsverstärkers einstellenden Spannungen als ungleich eingestuft werden, ist über die W/L-Verhältnisse der zum einem Stromspiegel verschalteten Transistoren T7 bis T10 einstellbar.

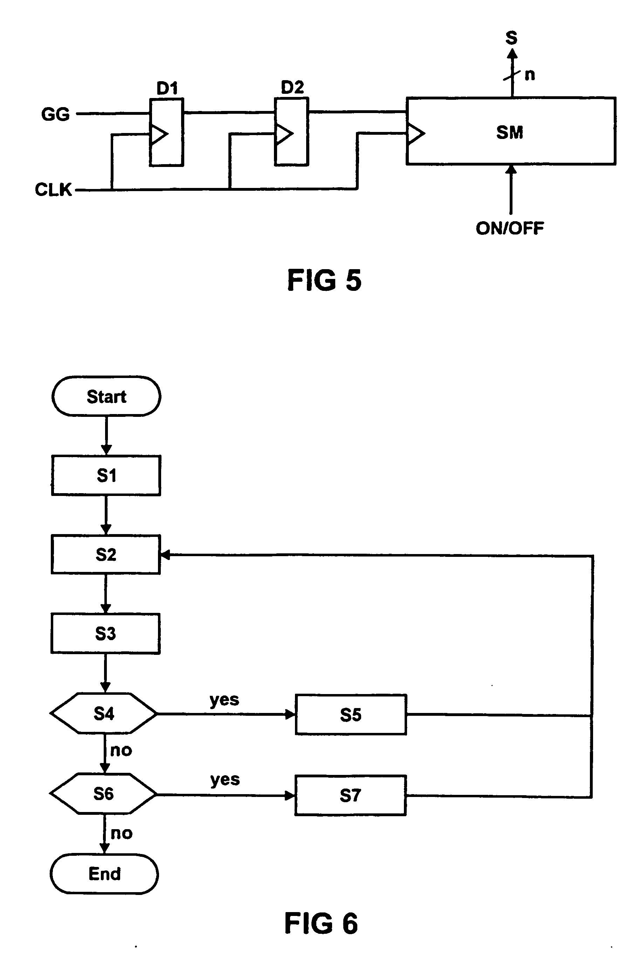

In der Figur 5 ist ein möglicher Aufbau der Steuereinrichtung SE gezeigt.

Die Steuereinrichtung SE umfaßt im betrachteten Beispiel zwei D-Flip-Flops D1 und D2 sowie eine sogenannte state machine SM, wobei die D-Flip-Flops D1 und D2 und die state machine SM mit einem gemeinsamen Takt CLK versorgt werden.

Die D-Flip-Flops D1 und D2 dienen zur Synchronisation von Gleichgewichtsdetektor GGD und Steuereinrichtung SE.

In der state machine SM wird (nach einem über ein Signal ON/OFF erfolgenden Anstoß) basierend auf dem ihr über die D-Flip-Flops zugeführten Ausgangssignal GG des Gleichgewichtsdetektors GGD festgelegt, ob und gegebenenfalls welche der vorhandenen Kondensatoren (durch ein Öffnen bzw. Schließen der den betreffenden Kondensatoren zugeordneten Schaltern S21 bis Sn2) zu aktivieren und zu deaktivieren sind.

Die state machine SM arbeitet im betrachteten Beispiel wie es in einem in Figur 6 dargestellten Ablaufdiagramm veranschaulicht ist.

Demnach wartet die state machine SM zunächst darauf, daß der von ihrer durchzuführende Selbstabgleich durchzuführen ist (Schritt S1). Wann mit dem Selbstabgleich zu beginnen ist, wird der state machine SM durch das bereits erwähnte, ihr von außen zugeführte Signal ON/OFF signalisiert.

Wenn der state machine SM durch das Signal ON/OFF signalisiert wurde, daß ein Selbstabgleich durchzuführen ist, wartet sie auf ein Ereignis, das eine den Operationsverstärker aus dem Gleichgewicht bringende Veränderung der an den Eingangsanschlüssen IN1 und IN2 des Operationsverstärkers anliegenden Spannungen zur Folge hat (Schritt S2). Dieses Ereignis ist eingetreten, wenn das der state machine SM vom Gleichgewichtsdetektor GGD zugeführte Signal GG vom Pegel 1 auf den Pegel 0 springt.

Danach wartet die state machine SM auf den Zeitpunkt, zu dem das der state machine SM vom Gleichgewichtsdetektor GGD zugeführte Signal GG vom Pegel 0 auf den Pegel 1 springt, und bestimmt die (Warte-)Zeit, bis zu welcher dies geschehen ist (Schritt S3).

Im Anschluß daran überprüft die state machine SM, ob die in Schritt S3 ermittelte Wartezeit größer als ein oberer Grenzwert für die Wartezeit (ein oberer Grenzwert für die Dauer des Einschwingvorganges) ist (Schritt S4).

Wenn die Wartezeit größer als der obere Grenzwert ist, schaltet die state machine SM einen oder mehrere der Kondensatoren C2 bis Cn durch Öffnen der zugeordneten Schalter ab und verringert dadurch die wirksame Kompensationskapazität (Schritt S5); im Anschluß daran erfolgt ein Rücksprung auf den Schritt S2.

Wenn die Wartezeit nicht größer als der obere Grenzwert ist, überprüft die state machine SM, ob die Wartezeit kleiner ist als ein unterer Grenzwert für die Wartezeit (ein unterer Grenzwert für die Dauer des Einschwingvorganges) ist (Schritt S6).

Wenn die Wartezeit kleiner als der untere Grenzwert ist, schaltet die state machine SM einen oder mehrere der Kondensatoren C2 bis Cn durch Schließen der zugeordneten Schalter zu und erhöht dadurch die wirksame Kompensationskapazität (Schritt S7); im Anschluß daran erfolgt ein Rücksprung auf den Schritt S2.

Wenn die Wartezeit nicht kleiner als der untere Grenzwert ist, also wenn die Wartezeit zwischen dem oberen Grenzwert und dem unteren Grenzwert liegt, ist die Kompensationskapazität so eingestellt, daß der Operationsverstärker wunschgemäß schnell und stabil läuft. Damit ist der Selbstabgleich beendet; die state machine SM springt auf den Schritt S1 zurück, wo sie auf einen Befehl für einen erneuten Selbstabgleich wartet.

Es dürfte einleuchten, daß die Vorgehensweise beim Selbstabgleich mannigfaltig modifizierbar ist. Insbesondere wenn die zu- und abschaltbaren Kondensatoren C2 bis Cn unterschiedliche Kapazitäten aufweisen, kann es sich als vorteilhaft erweisen,
- wenn es von der Höhe der Differenz der Wartezeit und den Grenzwerten abhängig gemacht wird, welcher Kondensator oder welche Kondensatoren jeweils zugeschaltet bzw. abgeschaltet werden, und/oder
- wenn eine Verringerung der wirksamen Kompensationskapazität (Schritt S5) dadurch bewerkstelligt wird, daß ein oder mehrere Kondensatoren abgeschaltet, und gleichzeitig ein oder mehrere Kondensatoren mit einer insgesamt niedrigeren Kapazität zugeschaltet werden, und/oder wenn eine Erhöhung der wirksamen Kompensationskapazität (Schritt S7) dadurch bewerkstelligt wird, daß ein oder mehrere Kondensatoren abgeschaltet, und gleichzeitig ein oder mehrere Kondensatoren mit einer insgesamt höheren Kapazität zugeschaltet werden.

Der Selbstabgleich muß auch nicht unter Steuerung durch die state machine SM durchgeführt werden; die Ablaufsteuerung kann auch durch eine beliebige andere Einrichtung, auch durch eine programmgesteuerte Einheit wie einen Mikroprozessor oder Mikrocontroller erfolgen.

Bei den vorstehenden Ausführungen wurde davon ausgegangen, daß der Operationsverstärker während des Selbstabgleichs Eingangssignale erhält, die sich so schnell und in einem solchen Umfang verändern, wie es im normalen Betrieb des Operationsverstärker zu erwarten ist. Dadurch erfolgt der Selbstabgleich unter Bedingungen wie sie auch im normalen Betrieb des Operationsverstärkers auftreten.

In vielen Systemen gibt während des Selbstabgleichs von Haus aus hinreichend schnelle und umfangreiche Veränderungen der Eingangssignale.

Sollte dies nicht der Fall sein, müssen während des Selbstabgleichs entsprechende Signale eingeschleust werden. Bei den Signalen kann es sich zum Beispiel um Rechtecksignale handeln. Die Erzeugung und Einschleusung solcher Signale während des Selbstabgleichs ist problemlos möglich und bedarf keine näheren Erläuterung.

Bei vielen Operationsverstärkern kann alleine durch das Zuschalten oder Abschalten der Kondensatoren C2 bis Cn bewirkt werden, daß der Operationsverstärker einen Einschwingvorgang mit ausreichender Amplitude durchführt, so daß sich der Vorgang des Selbstabgleichs sein eigenes Stimulussignal liefert. Dies gilt insbesondere, wenn die zuzuschaltenden Kondensatoren vor dem Zuschalten durch eine spezielle Ladevorrichtung geladen werden.

Der Selbstabgleich kann prinzipiell zu beliebigen Zeitpunkten und beliebig oft durchgeführt werden.

Völlig problemlos und im allgemeinen ohne jede negative Auswirkung auf das den Operationsverstärker enthaltenden System ist der Selbstabgleich, wenn er gleich nach dem Einschalten des Systems durchgeführt wird.

Der Selbstabgleich kann aber auch zu späteren Zeitpunkten erstmals oder erneut durchgeführt werden, ohne den Betrieb des den Operationsverstärkers enthaltenden Systems zu stören.

Dies ist vor allem bei Systemen, die zeitdiskret arbeiten problemlos der Fall. Hier muß nur dafür gesorgt werden, daß der Selbstabgleich zu Zeiten durchgeführt wird, zu denen der Operationsverstärker (das Ausgangssignal desselben) gerade nicht benötigt wird.

Ein während des Betriebes des Operationsverstärkers erfolgender Selbstabgleich ist aber auch bei zeitkontinuierlich arbeitenden Systemen häufig möglich. Auch in solchen Systemen eingesetzte Operationsverstärker werden nicht immer benötigt oder können zwischenzeitlich wie beschrieben eingestellt werden. Dies ist beispielsweise der Fall, wenn, wie etwa beim Vorverstärker eines A/D-Wandlers, das Ausgangssignal des Operationsverstärkers nur zu bestimmten Zeitpunkten benötigt oder abgetastet wird. Auch hier kann zu Zeiten zu denen der Operationsverstärker (das Ausgangssignal desselben) gerade nicht benötigt wird, ein Selbstabgleich durchgeführt werden.

Es kann auch vorgesehen werden, den Selbstabgleich nicht an dem gerade arbeitenden Operationsverstärker, sondern an einem identisch aufgebauten zweiten Operationsverstärker durchzuführen, und dann
- die sich dabei ergebende Konfiguration der Konfigurationsschaltung zu einem geeigneten Zeitpunkt auf den ersten Operationsverstärker zu übertragen, oder
- die Operationsverstärker durch eine Umschaltung der Signalpfade auszutauschen.

Es könnte auch vorgesehen werden, den Selbstabgleich nur in bestimmten Testphasen durchzuführen, und die dabei ermittelten Einstellungen in einem nichtflüchtigen Speicher zu speichern. Dabei können auch mehrere Einstellungs-Sätze gespeichert werden, die sich dann wahlweise (beispielsweise abhängig von Temperatur) verwenden lassen. Dann müßten während des normalen Betriebes des Operationsverstärkers keine Überprüfungen mehr vorgenommen werden; die für die Konfiguration der Kompensationsschaltung benötigten Informationen könnten aus dem nichtflüchtigen Speicher ausgelesen werden.

Es wäre auch denkbar, die Schalter S21 bis Sn2 vollständig oder teilweise durch Fuses zu ersetzen.

Wie bei der vorstehend beschriebenen Kompensationsschaltung die Kondensatoren zugeschaltet und abgeschaltet werden können, können auch beliebige andere elektrische Bauelemente wie beispielsweise Widerstände, Spulen, Dioden, Transistoren etc. selektiv und unabhängig voneinander zugeschaltet oder abgeschaltet werden.

Zusätzlich oder alternativ können auch Signalpfade umgeschaltet werden.

Selbstverständlich können diese Einstellungen nicht nur in Abhängigkeit vom Einschwingverhalten des Operationsverstärkers, sonder auch abhängig von beliebigen anderen Eigenschaften oder Parametern erfolgen.

Durch die beschriebene Kompensationsschaltung und das beschriebene Kompensationsverfahren kann auch dann, wenn sich die zur Kompensation benötigten Elemente nur mit großen Toleranzen herstellen lassen , gewährleistet werden, daß der Operationsverstärker unter allen Umständen stets wunschgemäß schnell und stabil arbeitet. Es kann sogar eine dynamische Anpassung an die jeweils aktuellen Bedingungen und Anforderungen vorgenommen werden.

### Bezugszeichenliste

- A: Eingangsanschluß von R und GGD
- AND: UND-Glied
- B: Eingangsanschluß von R und GGD
- CLK: Takt
- Cx: Kondensatoren
- Dx: D-Flip-Flops
- GG: Ausgangssignal von GGD
- GGD: Gleichgewichtsdetektor
- INx: Eingangsanschlüsse von OPAMP
- INVx: Inverter
- IQ: Stromquelle
- KOMP: Kompensationsschaltung
- ON/OFF: Einschaltsignal für SM
- OPAMP: Operationsverstärker
- R: Regler
- SE: Steuereinrichtung
- SM: State Machine
- Sx: Schalter
- Tx: Transistoren

## Patentansprüche

1. Kompensationsschaltung zur Abschwächung oder Beseitigung unerwünschter Eigenschaften eines Operationsverstärkers, wobei die Elemente der Kompensationssschaltung (KOMP) zumindest teilweise selektiv aktivierbar und deaktivierbar und/oder unterschiedlich mit anderen Elementen der Kompensationsschaltung und/oder dem Operationsverstärker verschaltbar sind, und wobei die Kompensationsschaltung (KOMP) einen Regler (R) enthält, der den Rest der Kompensationsschaltung nach bestimmten Vorgaben konfiguriert,
**dadurch gekennzeichnet,**
**daß** der Regler (R) dazu ausgelegt ist, die Kompensationsschaltung (KOMP) abhängig von der Dauer und/oder vom Verlauf des Einschwingvorganges des Operationsverstärkers zu konfigurieren.

2. Kompensationsschaltung nach Anspruch 1,
**dadurch gekennzeichnet,**
**daß** die Kompensationsschaltung (KOMP) eine Kompensationsschaltung zur Korrektur des Frequenzganges des Operationsverstärkers ist.

3. Kompensationsschaltung nach Anspruch 1 oder 2,
**dadurch gekennzeichnet,**
**daß** der Regler (R) dazu ausgelegt ist, die Kompensationsschaltung (KOMP) so zu konfigurieren, daß der Operationsverstärker wunschgemäß schnell und stabil läuft.

4. Kompensationsschaltung nach einem der vorhergehenden Ansprüche,
**dadurch gekennzeichnet,**
**daß** der Regler (R) dazu ausgelegt ist, die Dauer und den Verlauf des Einschwingvorganges aus dem Größenverhältnis der sich an den Eingangsanschlüssen (IN1, IN2) des Operationsverstärkers einstellenden Spannungen zu ermitteln.

5. Kompensationsschaltung nach Anspruch 4,
**dadurch gekennzeichnet,**
**daß** der Regler (R) so aufgebaut ist, daß er erkennen kann, ob der Einschwingvorgang noch andauert, und daß der Regler (R) den Umstand, daß der Einschwingvorgang noch andauert, daran erkennt, daß die sich an den Eingangsanschlüssen (IN1, IN2) des Operationsverstärkers einstellenden Spannungen nicht ungefähr gleich groß sind.

6. Kompensationsschaltung nach Anspruch 4 oder 5,
**dadurch gekennzeichnet,**
**daß** der Regler (R) so aufgebaut ist, daß er erkennen kann, ob der Einschwingvorgang beendet ist, und daß der Regler (R) den Umstand, daß der Einschwingvorgang beendet ist, daran erkennt, daß die sich an den Eingangsanschlüssen (IN1, IN2) des Operationsverstärkers einstellenden Spannungen ungefähr gleich groß sind.

7. Kompensationsschaltung nach einem der Ansprüche 4 bis 6,
**dadurch gekennzeichnet,**
**daß** der Regler (R) so aufgebaut ist, daß er erkennen kann, ob der Operationsverstärker instabil ist, und daß der Regler (R) den Umstand, daß der Operationsverstärker instabil ist, daran erkennt, daß die sich an den Eingangsanschlüssen (IN1, IN2) des Operationsverstärkers einstellenden Spannungen abwechselnd ungefähr gleich groß und unterschiedlich groß sind.

8. Kompensationsschaltung nach einem der vorhergehenden Ansprüche,
**dadurch gekennzeichnet,**
**daß** der Regler (R) dazu ausgelegt ist, eine in der Kompensationsschaltung (KOMP) vorhandene Kapazität zu verringern, wenn die Dauer des Einschwingvorganges einen oberen Grenzwert überschreitet.

9. Kompensationsschaltung nach einem der vorhergehenden Ansprüche,
**dadurch gekennzeichnet,**
**daß** der Regler (R) eine in der Kompensationsschaltung (KOMP) vorhandene Kapazität erhöht, wenn der Operationsverstärker instabil ist.

10. Kompensationsschaltung nach einem der vorhergehenden Ansprüche,
**dadurch gekennzeichnet,**
**daß** der Regler (R) dazu ausgelegt ist, eine in der Kompensationsschaltung (KOMP) vorhandene Kapazität zu erhöhen, wenn die Dauer des Einschwingvorganges einen unteren Grenzwert unterschreitet.

11. Kompensationsschaltung nach einem der vorhergehenden Ansprüche,
**dadurch gekennzeichnet,**
**daß** der Regler (R) in der Lage ist, die Einstellung der Kompensationsschaltung (KOMP) während des normalen Betriebes des Operationsverstärkers durchzuführen.

12. Verfahren zur Abschwächung oder Beseitigung unerwünschter Eigenschaften eines Operationsverstärkers, wobei sich innerhalb oder außerhalb des Operationsverstärkers einstellende Verhältnisse, die Rückschlüsse auf das Vorliegen und/oder das Ausmaß der unerwünschten Eigenschaften des Operationsverstärkers gestatten, ermittelt werden, und wobei eine zur Abschwächung oder Beseitigung der unerwünschten Eigenschaften des Operationsverstärkers vorgesehene Kompensationssschaltung (KOMP) abhängig vom Ergebnis der Ermittlung gesteuert wird, und wobei die Kompensationsschaltung (KOMP) so gesteuert wird, daß der Operationsverstärker wunschgemäß schnell und stabil läuft,
**dadurch gekennzeichnet,**
**daß** es aus der Dauer und/oder dem Verlauf des Einschwingvorganges des Operationsverstärkers ermittelt wird, ob der Operationsverstärker wunschgemäß schnell und stabil läuft.

13. Verfahren nach Anspruch 12,
**dadurch gekennzeichnet,**
**daß** die Steuerung der Kompensationsschaltung (KOMP) ein Aktivieren und/oder Deaktivieren von in der Kompensationsschaltung enthaltenen Elementen (C0-Cn) und/oder eine Variierung der Verschaltung von in der Kompensationsschaltung enthaltenen Elementen mit anderen Elementen der Kompensationsschaltung und/oder dem Operationsverstärker umfaßt.

14. Verfahren nach Anspruch 12 oder 13,
**dadurch gekennzeichnet,**
**daß** die Steuerung der Kompensationsschaltung (KOMP) durch Betätigung von in dieser vorhandenen Schaltelementen (S21-Sn2) erfolgt.

15. Verfahren nach einem der Ansprüche 12 bis 14,
**dadurch gekennzeichnet,**
**daß** die Dauer und/oder dar Verlauf des Einschwingvorganges aus dem Größenverhältnis der sich an den Eingangsanschlüssen (IN1, IN2) des Operationsverstärkers einstellenden Spannungen ermittelt wird.

16. Verfahren nach Anspruch 15,
**dadurch gekennzeichnet,**
**daß** davon ausgegangen wird, daß der Einschwingvorgang noch andauert, wenn die sich an den Eingangsanschlüssen des Operationsverstärkers einstellenden Spannungen nicht ungefähr gleich groß sind.

17. Verfahren nach Anspruch 15 oder 16,
**dadurch gekennzeichnet,**
**daß** davon ausgegangen wird, daß der Einschwingvorgang beendet ist, wenn die sich an den Eingangsanschlüssen (IN1, IN2) des Operationsverstärkers einstellenden Spannungen ungefähr gleich groß sind.

18. Verfahren nach einem der Ansprüche 15 bis 17,
**dadurch gekennzeichnet,**
**daß** davon ausgegangen wird, daß der Operationsverstärker instabil ist, wenn die sich an den Eingangsanschlüssen (IN1, IN2) des Operationsverstärkers einstellenden Spannungen abwechselnd ungefähr gleich groß und unterschiedlich groß sind.

19. Verfahren nach Anspruch 16 oder 17,
**dadurch gekennzeichnet,**
**daß** eine in der Kompensationsschaltung (KOMP) vorhandene Kapazität verringert wird, wenn die Dauer des Einschwingvorganges einen oberen Grenzwert überschreitet.

20. Verfahren nach Anspruch 19,
**dadurch gekennzeichnet,**
**daß** die Verringerung der Kapazität durch Deaktivieren eines aktivierten Kondensators erfolgt.

21. Verfahren nach Anspruch 18,
**dadurch gekennzeichnet,**
**daß** eine in der Kompensationsschaltung (KOMP) vorhandene Kapazität erhöht wird, wenn der Operationsverstärker instabil ist.

22. Verfahren nach Anspruch 16 oder 17,
**dadurch gekennzeichnet,**
**daß** eine in der Kompensationsschaltung (KOMP) vorhandene Kapazität erhöht wird, wenn die Dauer des Einschwingvorganges einen unteren Grenzwert unterschreitet.

23. Verfahren nach Anspruch 22,
**dadurch gekennzeichnet,**
**daß** die Erhöhung der Kapazität durch Aktivieren eines nicht aktivierten Kondensators erfolgt.

24. Verfahren nach einem der Ansprüche 12 bis 23,
**dadurch gekennzeichnet,**
**daß** die Einstellung der Kompensationsschaltung während des normalen Betriebes des Operationsverstärkers durchgeführt wird.

## Claims

1. Compensation circuit for attenuating or eliminating undesired properties of an operational amplifier, wherein the elements of the compensation circuit (KOMP) can be activated and deactivated at least partially selectively and/or can be connected in different ways to other elements of the compensation circuit and/or to the operational amplifier, and wherein the compensation circuit (KOMP) contains a regulator (R) which configures the rest of the compensation circuit according to specific specifications, **characterized in that** the regulator (R) is designed to configure the compensation circuit (KOMP) as a function of the duration and/or the profile of the transient response of the operational amplifier.

2. Compensation circuit according to Claim 1, **characterized in that** the compensation circuit (KOMP) is a compensation circuit for correcting the frequency response of the operational amplifier.

3. Compensation circuit according to Claim 1 or 2, **characterized in that** the regulator (R) is designed to configure the compensation circuit (KOMP) in such a way that the operational amplifier operates in a fast and stable fashion according to requirements.

4. Compensation circuit according to one of the preceding claims, **characterized in that** the regulator (R) is designed to determine the duration and the profile of the transient response from the ratio of the magnitudes of the voltages which are established at the input terminals (IN2, IN2) of the operational amplifier.

5. Compensation circuit according to Claim 4, **characterized in that** the regulator (R) is constructed in such a way that it can detect whether the transient response is still occurring, and that the regulator (R) detects that the transient response is still occurring from the fact that the voltages which are established at the input terminals (IN1, IN2) of the operational amplifier are not approximately of the same magnitude.

6. Compensation circuit according to Claim 4 or 5, **characterized in that** the regulator (R) is constructed in such a way that it can detect whether the transient response has ended, and that the regulator (R) detects that the transient response has ended from the fact that the voltages which are established at the input terminals (IN1, IN2) of the operational amplifier are approximately of the same magnitude.

7. Compensation circuit according to one of Claims 4 to 6, **characterized in that** the regulator (R) is constructed in such a way that it can detect whether the operational amplifier is unstable, and that the regulator (R) detects that the operational amplifier is unstable from the fact that the voltages which are established at the input terminals (IN1, IN2) of the operational amplifier are alternately approximately of the same magnitude and of different magnitudes.

8. Compensation circuit according to one of the preceding claims, **characterized in that** the regulator (R) is designed to reduce a capacitance present in the compensation circuit (KOMP) if the duration of the transient response exceeds an upper limiting value.

9. Compensation circuit according to one of the preceding claims, **characterized in that** the regulator (R) increases a capacitance present in the compensation circuit (KOMP) if the operational amplifier is unstable.

10. Compensation circuit according to one of the preceding claims, **characterized in that** the regulator (R) is designed to increase a capacitance present in the compensation circuit (KOMP) if the duration of the transient response drops below a lower limiting value.

11. Compensation circuit according to one of the preceding claims, **characterized in that** the regulator (R) is able to adjust the compensation circuit (KOMP) during the normal operation of the operational amplifier.

12. Method for attenuating or eliminating undesired properties of an operational amplifier, wherein conditions which are established inside or outside the operational amplifier and which permit conclusions to be drawn as to the presence and/or the degree of the undesired properties of the operational amplifier are determined, and wherein a compensation circuit (KOMP) which is provided for attenuating or eliminating the undesired properties of the operational amplifier is controlled as a function of the result of the determination, and wherein the compensation circuit (KOMP) is controlled in such a way that the operational amplifier operates in a fast and stable fashion according to requirements, **characterized in that** whether the operational amplifier is operating in a fast and stable fashion according to requirements is determined from the duration and/or the profile of the transient response of the operational amplifier.

13. Method according to Claim 12, **characterized in that** the control of the compensation circuit (KOMP) comprises activating and/or deactivating elements (C0-Cn) contained in the compensation circuit and/or varying the connection of elements contained in the compensation circuit to other elements of the compensation circuit and/or to the operational amplifier.

14. Method according to Claim 12 or 13, **characterized in that** the compensation circuit (KOMP) is controlled by actuating switching elements (S21-Sn2) present in said circuit.

15. Method according to one of Claims 12 to 14, **characterized in that** the duration and/or the profile of the transient response is determined from the ratio of the magnitudes of the voltages which are established at the input terminals (IN1, IN2) of the operational amplifier.

16. Method according to Claim 15, **characterized in that** it is assumed that the transient response is still occurring if the voltages which are established at the input terminals of the operational amplifier are not approximately of the same magnitude.

17. Method according to Claim 15 or 16, **characterized in that** it is assumed that the transient response is ended if the voltages which are established at the input terminals (IN1, IN2) of the operational amplifier are approximately of the same magnitude.

18. Method according to one of Claims 15 to 17, **characterized in that** it is assumed that the operational amplifier is unstable if the voltages which are established at the input terminals (IN1, IN2) of the operational amplifier are alternately approximately of the same magnitude and of different magnitudes.

19. Method according to Claim 16 or 17, **characterized in that** a capacitance which is present in the compensation circuit (KOMP) is reduced if the duration of the transient response exceeds an upper limiting value.

20. Method according to Claim 19, **characterized in that** the capacitance is reduced by deactivating an activated capacitor.

21. Method according to Claim 18, **characterized in that** a capacitance which is present in the compensation circuit (KOMP) is increased if the operational amplifier is unstable.

22. Method according to Claim 16 or 17, **characterized in that** a capacitance which is present in the compensation circuit (KOMP) is increased if the duration of the transient response drops below a lower limiting value.

23. Method according to Claim 22, **characterized in that** the capacitance is increased by activating a non-activated capacitor.

24. Method according to one of Claims 12 to 13, **characterized in that** the compensation circuit is adjusted during the normal operation of the operational amplifier.

## Revendications

1. Circuit de compensation pour atténuer ou éliminer les propriétés non désirées d'un amplificateur opérationnel, les éléments du circuit de compensation (KOMP) pouvant être activés ou désactivés en partie de façon sélective et/ou être connectés différemment à d'autres éléments du circuit de compensation et/ou de l'amplificateur opérationnel et le circuit de compensation (KOMP) contenant un régulateur (R) qui configure le reste du circuit de compensation en fonction des paramètres définis par défaut, **caractérisé en ce que** le régulateur (R) est conçu pour configurer le circuit de compensation (KOMP) en fonction de la durée et/ou de la courbe du phénomène de distorsion de l'amplificateur opérationnel.

2. Circuit de compensation selon la revendication 1, **caractérisé en ce que** le circuit de compensation (KOMP) est un circuit de compensation pour corriger la réponse fréquentielle de l'amplificateur opérationnel.

3. Circuit de compensation selon la revendication 1 ou 2, **caractérisé en ce que** le régulateur (R) est conçu pour configurer le circuit de compensation (KOMP) de telle sorte que l'amplificateur opérationnel fonctionne comme souhaité de façon rapide et stable.

4. Circuit de compensation selon l'une quelconque des revendications précédentes, **caractérisé en ce que** le régulateur (R) est conçu pour déterminer la durée et la courbe du phénomène de distorsion à partir du rapport de grandeur des tensions apparaissant au niveau des raccords d'entrée (IN1, IN2) de l'amplificateur opérationnel.

5. Circuit de compensation selon la revendication 4, **caractérisé en ce que** le régulateur (R) est conçu de façon à pouvoir reconnaître si le phénomène de distorsion perdure et **en ce que** le régulateur (R) reconnaît l'état dans lequel le phénomène de distorsion perdure **en ce que** les tensions apparaissant au niveau des raccords d'entrée (IN1, IN2) de l'amplificateur opérationnel ne sont approximativement pas de la même grandeur.

6. Circuit de compensation selon la revendication 4 ou 5, **caractérisé en ce que** le régulateur (R) est conçu de façon à pouvoir reconnaître si le phénomène de distorsion est terminé et **en ce que** le régulateur (R) reconnaît l'état dans lequel le phénomène de distorsion est terminé **en ce que** les tensions apparaissant au niveau des raccords d'entrée (IN1, IN2) de l'amplificateur opérationnel sont approximativement de la même grandeur.

7. Circuit de compensation selon l'une quelconque des revendications 4 à 6, **caractérisé en ce que** le régulateur (R) est conçu de façon à pouvoir reconnaître si l'amplificateur opérationnel est instable et **en ce que** le régulateur (R) reconnaît l'état dans lequel l'amplificateur opérationnel est instable **en ce que** les tensions apparaissant au niveau des raccords d'entrée (IN1, IN2) de l'amplificateur opérationnel sont alternativement approximativement de grandeur égale et de grandeur différente.

8. Circuit de compensation selon l'une quelconque des revendications précédentes, **caractérisé en ce que** le régulateur (R) est conçu pour limiter une capacité présente dans le circuit de compensation (KOMP) lorsque la durée du phénomène de distorsion dépasse une valeur limite supérieure.

9. Circuit de compensation selon l'une quelconque des revendications précédentes, **caractérisé en ce que** le régulateur (R) augmente une capacité présente dans le circuit de compensation (KOMP) lorsque l'amplificateur opérationnel est instable.

10. Circuit de compensation selon l'une quelconque des revendications précédentes, **caractérisé en ce que** le régulateur (R) est conçu pour augmenter une capacité présente dans le circuit de compensation (KOMP) lorsque la durée du phénomène de distorsion passe en dessous d'une valeur limite inférieure.

11. Circuit de compensation selon l'une quelconque des revendications précédentes, **caractérisé en ce que** le régulateur (R) est en position de réaliser le réglage du circuit de compensation (KOMP) en situation de fonctionnement normal de l'amplificateur opérationnel.

12. Procédé pour atténuer ou éliminer les propriétés non désirées d'un amplificateur opérationnel, les rapports apparaissant à l'intérieur ou à l'extérieur de l'amplificateur opérationnel étant déterminés, afin de tirer des conclusions sur la présence et/ou l'étendue des propriétés non désirées de l'amplificateur opérationnel, et un circuit de compensation (KOMP) prévu pour atténuer ou éliminer les propriétés non désirées de l'amplificateur opérationnel étant piloté en fonction du résultat de la détermination, et le circuit de compensation (KOMP) étant piloté de telle sorte que l'amplificateur opérationnel fonctionne comme souhaité de façon rapide et stable, **caractérisé en ce que** l'on détermine à partir de la durée et/ou de la courbe du phénomène de distorsion de l'amplificateur opérationnel si l'amplificateur opérationnel fonctionne comme souhaité de façon rapide et stable.

13. Procédé selon la revendication 12, **caractérisé en ce que** le pilotage du circuit de compensation (KOMP) comprend une activation et/ou désactivation des éléments (C0-Cn) contenus dans le circuit de commutation et/ou une connexion différente des éléments contenus dans le circuit de compensation aux d'autres éléments du circuit de compensation et/ou de l'amplificateur opérationnel.

14. Procédé selon la revendication 12 ou 13, **caractérisé en ce que** le pilotage du circuit de compensation (KOMP) est réalisé par actionnement des éléments de commutation (S21-Sn2) présents dans celui-ci.

15. Procédé selon l'une quelconque des revendications 12 à 14, **caractérisé en ce que** la durée et/ou la courbe du phénomène de distorsion sont déterminées à partir du rapport de grandeur des tensions apparaissant au niveau des raccords d'entrée (IN1, IN2) de l'amplificateur opérationnel.

16. Procédé selon la revendication 15, **caractérisé en ce que** l'on prend comme point de départ que le phénomène de distorsion perdure encore lorsque les tensions apparaissant au niveau des raccords d'entrée de l'amplificateur opérationnel ne sont pas approximativement de même grandeur.

17. Procédé selon la revendication 15 ou 16, **caractérisé en ce que** l'on prend comme point de départ que le phénomène de distorsion est terminé lorsque les tensions apparaissant au niveau des raccords d'entrée (IN1, IN2) de l'amplificateur opérationnel sont approximativement de la même grandeur.

18. Procédé selon l'une quelconque des revendications 15 à 17, **caractérisé en ce que** l'on prend comme point de départ que l'amplificateur opérationnel est instable lorsque les tensions apparaissant au niveau des raccords d'entrée (IN1, IN2) de l'amplificateur opérationnel sont alternativement approximativement de même grandeur et de grandeur différente.

19. Procédé selon la revendication 16 ou 17, **caractérisé en ce qu'**une capacité présente dans le circuit de compensation (KOMP) est réduite lorsque la durée du phénomène de distorsion dépasse une valeur limite supérieure.

20. Procédé selon la revendication 19, **caractérisé en ce que** la limitation de la capacité est réalisée par désactivation d'un condensateur activé.

21. Procédé selon la revendication 18, **caractérisé en ce qu'**une capacité présente dans le circuit de compensation (KOMP) est augmentée lorsque l'amplificateur opérationnel est instable.

22. Procédé selon la revendication 16 ou 17, **caractérisé en ce qu'**une capacité présente dans le circuit de compensation (KOMP) est augmentée lorsque la durée du phénomène de distorsion passe en dessous d'une valeur limite inférieure.

23. Procédé selon la revendication 22, **caractérisé en ce que** l'augmentation de la capacité est réalisée par activation d'un condensateur non activé.

24. Procédé selon l'une quelconque des revendications 12 à 23, **caractérisé en ce que** le réglage du circuit de compensation se fait en situation de fonctionnement normal de l'amplificateur opérationnel.
